# FASCICULE DE BREVET EUROPEEN

(11) **EP 2 871 524 B1**
(45) Date de publication et mention de la délivrance du brevet: **05.09.2018**
(21) Numéro de dépôt: 14191368.1
(22) Date de dépôt: 31.10.2014
(51) Int. Cl.: G03F 7/20, H05K 13/00, H01L 21/68, H05K 3/00

(54) **Plateau pour machine d'insolation et machine d'insolation le comprenant**
Träger für eine Belichtungsmaschine und einen solchen Träger enthaltende Belichtungsmaschine
Tray for an exposure machine and exposure machine comprising it

(30) Priorité: 06.11.2013 FR 1360868
(43) Date de publication de la demande: 13.05.2015
(73) Titulaire: Altix, 27100 Val de Reuil (FR)
(72) Inventeur: Leboucher, Arnaud, R., 76520 FRANQUEVILLE-SAINT-PIERRE (FR)
(74) Mandataire: Joanny, Damien Henri Xavier

(56) Documents cités:
- JP-A- H0 749 572
- JP-A- 2008 275 807
- US-A- 5 797 317
- US-A1- 2009 086 009

## Description

### DOMAINE DE L'INVENTION

Le présent exposé concerne un plateau pour machine d'insolation de panneaux, ainsi qu'une telle machine, permettant de maintenir et de plaquer un panneau afin de le présenter en vis-à-vis d'un dispositif d'insolation.

Le domaine d'application de cette invention est principalement celui des circuits imprimés mais l'invention peut également être utilisée dans tous les domaines utilisant des procédés de transfert d'image tel celui des écrans LCD, des écrans tactiles, des cellules photovoltaïques ou encore celui de la fabrication de pièces de micromécanique par découpe chimique.

### ETAT DE LA TECHNIQUE ANTERIEURE

Parmi les techniques d'insolation de panneaux et de transfert d'image, la technique dite de « direct imaging », c'est-à-dire par imagerie directe, possède l'avantage de se passer de cliché physique, l'image à transférer étant directement projetée à partir d'un cliché numérique à l'aide, par exemple, d'une tête d'insolation munie d'une matrice de micro-miroirs commandables capable de projeter une image composée de pixels en laissant passer, ou non, la lumière d'une source lumineuse pour chaque pixel du cliché numérique. Cette technique facilite grandement la production, et surtout les changements de séries, car le cliché peut-être facilement reprogrammé par changement de fichier sans nécessiter de manipulation de la machine d'insolation elle-même.

Toutefois, de telles têtes d'insolation munie d'une matrice de micro-miroirs, qui représentent la technologie la plus souvent utilisée en « direct imaging », présentent le défaut de posséder de faibles profondeurs de champ, typiquement de l'ordre de 300 µm. Dès lors, afin que l'image transférée soit nette sur toute la surface du panneau, il faut s'assurer que ce dernier soit suffisamment plan.

Pour assurer cette planéité, les machines d'insolation traditionnelles sont généralement équipées de dispositifs d'aspiration venant plaquer par aspiration le panneau contre la surface de la table de travail. Toutefois, de tels dispositifs d'aspiration ne sont plus suffisants pour atteindre la planéité requise par de telles profondeurs de champ. En effet, certains panneaux, notamment pour circuits imprimés, peuvent être très épais, de l'ordre de plusieurs millimètres, et donc très rigides : dès lors, si le panneau est légèrement voilé, la force d'aspiration n'est pas suffisante pour corriger cette courbure du panneau. Les panneaux fins et souples, par exemple les couches internes de circuits imprimés ou encore les panneaux utilisés dans les domaines des écrans souples ou de la découpe chimique, posent eux aussi d'importants problèmes lorsqu'ils sont cornés : en effet, en raison de la distance importante entre la partie cornée du panneau et le dispositif d'aspiration, ce dernier ne peut saisir efficacement cette partie du panneau. De plus, dans un cas comme dans l'autre, certaines buses d'aspiration se retrouvent dans de telles circonstances à aspirer dans le vide, ce qui affaiblit la force d'aspiration de toutes les buses voisines appartenant au même réseau, réduisant ainsi le plaquage du panneau dans une zone importante.

Pour résoudre cette insuffisance des dispositifs d'aspiration connus, une solution a été proposée (voir JP 2008-275807 par exemple) dans laquelle la table de travail est équipée de quatre dispositifs d'immobilisation capables d'appuyer sur les bords du panneau afin de les plaquer contre la table de travail. Afin de pouvoir s'adapter à des tailles de panneaux différents, chacun de ces dispositifs est monté sur un chariot mobile en translation orthogonalement aux bords du panneau : ainsi, quelle que soit sa taille, le panneau est centré sur le centre de la table et chaque dispositif d'immobilisation se déplace vers l'intérieur de la table jusqu'à atteindre le bord du panneau qu'il détecte à l'aide de capteurs.

Toutefois, cette solution présente des problèmes d'ergonomie pour l'opérateur responsable du chargement des panneaux. En effet, dans la mesure où le panneau doit toujours être centré sur la table, il doit toujours être disposé à distance du bord de la table de travail, donc à distance du poste de l'opérateur : ce dernier doit donc porter à bout de bras le panneau et se pencher sur la table pour pouvoir disposer le panneau au centre de cette dernière. Cette position inconfortable est d'autant plus accentuée que le panneau est petit et qu'il doit donc être disposé loin du bord. On comprend naturellement que ceci entraîne une pénibilité importante pour l'opérateur ainsi que un risque de survenance de troubles musculo-squelettiques par exemple.

En outre, le centrage du panneau sur la table, qui doit être précis pour que l'alignement de l'image projetée sur le panneau soit correct, demande à l'opérateur de régler la position du panneau en translation selon deux directions différentes ainsi qu'en rotation autour de l'axe vertical, ce qui est d'autant plus difficile à réaliser précisément que le panneau est situé à distance de l'opérateur : la précision du positionnement du panneau est donc relativement faible, ce qui peut poser des problèmes d'alignement avec la tête d'insolation.

Les documents US 2009/0086009, JP H7-49572 et US 5 797 317 décrivent d'autres machines d'insolations munies de dispositifs d'immobilisation de différentes natures.

Il existe donc un réel besoin pour un plateau et une machine d'insolation permettant de maintenir et plaquer un panneau afin de le présenter en vis-à-vis d'un dispositif d'insolation et qui soient dépourvus, au moins en partie, des inconvénients inhérents aux dispositifs connus précités.

### PRESENTATION DE L'INVENTION

Le présent exposé concerne un plateau adapté pour présenter un panneau en vis-à-vis d'un dispositif d'insolation d'une machine d'insolation de panneaux, le plateau comprenant une surface de travail adaptée pour recevoir des panneaux de tailles différentes, ladite surface de travail étant sensiblement plane et possédant des premier et deuxième bords adjacents s'étendant selon des première et deuxième directions sensiblement orthogonales et définissant un coin de référence, un premier et un deuxième dispositif d'immobilisation d'un premier type et au moins un premier dispositif d'immobilisation d'un deuxième type, chacun étant actionnable entre un premier état d'immobilisation dans lequel il exerce une pression dirigée vers la surface de travail, définissant une position d'immobilisation, et un deuxième état de repos dans lequel ladite pression est relâchée, et un dispositif de positionnement prévu le long d'au moins une partie du premier bord et le long d'au moins une partie du deuxième bord ; les dispositifs d'immobilisation du premier type s'étendent respectivement le long d'au moins une partie des premier et deuxième bords, leurs positions d'immobilisation étant fixes dans un plan parallèle à la surface de travail ; et le dispositif d'immobilisation du deuxième type est mobile dans un plan parallèle à la surface de travail afin d'adapter sa position d'immobilisation en fonction de la taille du panneau utilisé.

Dans le présent exposé, on entend par « panneau » tout type de substrat, sensiblement plan, quelles que soient son épaisseur et sa rigidité. Il peut s'agir typiquement d'un panneau pour circuit imprimé ou micro-électronique mais également d'une feuille métallique qui subira une découpe chimique pour fabriquer des pièces micromécaniques, ou encore d'une feuille de plastique sur laquelle sera tracée des pistes conductrices pour la fabrication d'écrans tactile souples ou de cellules photovoltaïques.

Grâce à ce plateau et à l'utilisation d'une référence en coin, l'opérateur peut travailler au plus près du panneau, quelle que soit la taille de ce dernier. En effet, cette configuration prévoit que le panneau soit disposé contre les premier et deuxième bords de la surface de travail, ce qui permet à l'opérateur de se placer devant l'un de ces bords pour manipuler le panneau juste devant lui.

De cette manière, les gestes à accomplir par l'opérateur sont simples, rapides et moins fatigants : en particulier, la zone de chargement de panneau se trouvant ainsi juste devant lui, l'opérateur n'a pas à se pencher ou à travailler à bout de bras. L'ergonomie de son poste de travail est ainsi grandement améliorée et sa pénibilité réduite. En outre, on réduit le risque d'accidents du travail liés par exemple à des troubles musculo-squelettiques.

De plus, la précision du positionnement du panneau est également améliorée. En effet, la disposition du panneau à proximité de l'opérateur offre à ce dernier une meilleure visibilité et une meilleure précision d'exécution lors du positionnement du panneau sur la surface de travail. En outre, le dispositif de positionnement guide l'opérateur pour disposer correctement le panneau sur la surface de travail. La position du panneau étant plus précise, le positionnement de l'image transférée est plus précis, ce qui augmente la qualité du panneau insolé. Une telle précision de positionnement de l'image est d'autant plus importante dans le cas d'une insolation double face dans lequel des éléments de l'image recto doivent correspondre avec des éléments de l'image verso.

En outre, grâce à la configuration proposée se fondant sur la référence en coin, trois des quatre coins du panneau s'étendent le long des premier et deuxième bords et peuvent donc être maintenus efficacement par les dispositifs d'immobilisation du premier type sans réglage particulier de ces derniers, ces trois coins étant naturellement disposés au niveau de la position d'immobilisation de ces dispositifs d'immobilisation du premier type. De cette manière, contrairement à des dispositifs mobiles dont la position doit être réglée en fonction de la taille du panneau, on évite de potentielles erreurs de positionnement risquant de réduire l'efficacité du plaquage ou d'empiéter sur la zone utile du panneau.

De tels dispositifs d'immobilisation qui ne nécessite pas d'être déplacés le long de la surface de travail sont également plus simples à concevoir et à mettre en place : ils sont donc moins couteux. Ils sont également moins lourds, ce qui est un avantage important lorsque le plateau est mobile au sein de la machine d'insolation : en effet, ceci permet de réduire son inertie et ainsi d'améliorer sa précision de déplacement. On peut de plus obtenir ainsi des vitesses de déplacement du plateau plus importantes pour une précision donnée.

En outre, grâce à cette configuration, un seul dispositif d'immobilisation du deuxième type, c'est-à-dire mobile, est suffisant pour maintenir et plaquer le quatrième coin du panneau. De plus, grâce à la référence en coin et à la disposition très précise du panneau, il est possible de déplacer et de positionner précisément le dispositif d'immobilisation du deuxième type sur la simple connaissance de la taille du panneau. En particulier, un capteur visant à détecter les bords du panneau est superflu pour positionner ce dispositif d'immobilisation du deuxième type.

Dans certains modes de réalisation, le dispositif de positionnement comprend au moins un taquet prévu contre le premier bord et/ou le deuxième bord de la surface de travail. De préférence, il comprend une pluralité de taquets prévus contre le premier et le deuxième bord. Ces taquets facilitent le positionnement et assurent une excellente précision puisqu'il suffit de pousser le plateau contre ces taquets jusqu'en butée pour s'assurer du positionnement correct du panneau dans chaque direction ainsi qu'en rotation.

Dans certains modes de réalisation, ledit taquet est un pion faisant saillie sur la face supérieure du plateau et disposé contre ledit bord. Ces pions sont en effet faciles à mettre en place sur la face supérieure du plateau sans affecter la planéité de cette dernière.

Dans d'autres modes de réalisation, le dispositif de positionnement pourrait comprendre des repères visuels, telles des règles ou des réticules, ou une marche formée dans la face supérieure du plateau et délimitant ledit bord. Les dispositifs d'immobilisation du premier type pourraient également agir comme dispositif de positionnement dans leur état de repos en formant un taquet pour le panneau.

Dans certains modes de réalisation, le premier dispositif d'immobilisation du deuxième type est mobile en translation le long d'une course s'étendant au moins depuis un troisième bord de la surface de travail vers l'intérieur de la surface de travail sensiblement en direction du premier dispositif d'immobilisation du premier type. De cette manière, ce dispositif d'immobilisation du deuxième type peut facilement maintenir et plaquer un troisième bord du panneau et son quatrième coin quelle que soit la longueur du panneau. De préférence, ledit troisième bord s'étend selon la première direction.

Dans certains modes de réalisation, la course du premier dispositif d'immobilisation du deuxième type forme un angle avec la première direction compris strictement entre 45° et 90°. Dans la mesure où la largeur des panneaux décroit généralement en même temps que leur longueur, une telle course oblique permet d'adapter la position du dispositif d'immobilisation du deuxième type y compris à la dimension transversale du panneau : on rapproche en effet le dispositif d'immobilisation du deuxième bord afin qu'il puisse s'appliquer sur une longueur plus importante du troisième bord du panneau ou de manière plus centrée par rapport à ce bord.

Dans certains modes de réalisation, la course du premier dispositif d'immobilisation du deuxième type forme un angle avec la première direction compris strictement entre 65° et 75°. En effet, compte tenu des tailles courantes de panneaux et de leurs ratios longueur/largeur, cette plage d'angle permet un maintien efficace d'une large gamme de panneaux depuis des petits panneau de 25,4x25,4 cm jusqu'à de grands panneau de 76,2x61 cm. En particulier, on parvient ainsi à maintenir au moins deux tiers de la longueur du troisième bord des panneaux de taille conventionnelle.

Toutefois, dans d'autres modes de réalisation, la course du troisième dispositif d'immobilisation pourrait être sensiblement orthogonale à la première direction.

Dans certains modes de réalisation, le plateau comprend un deuxième dispositif d'immobilisation du deuxième type. Ce dernier peut permettre de maintenir et de plaquer un quatrième bord du panneau quelle que soit la taille de ce dernier.

Dans certains modes de réalisation, le deuxième dispositif d'immobilisation du deuxième type est mobile en translation le long d'une course s'étendant au moins depuis un quatrième bord de la surface de travail vers l'intérieur de la surface de travail et sensiblement en direction du deuxième dispositif d'immobilisation du premier type. De cette manière, ce dispositif d'immobilisation du deuxième type peut facilement maintenir et plaquer le quatrième bord du panneau quelle que soit la largeur du panneau. De préférence, ledit quatrième bord s'étend selon la deuxième direction.

Dans certains modes de réalisation, ladite course forme un angle avec la deuxième direction compris strictement entre 45° et 90°. De la même manière qu'annoncée précédemment, une telle course oblique permet de rapprocher le dispositif d'immobilisation du premier bord afin qu'il puisse s'appliquer sur une longueur plus importante du quatrième bord du panneau ou de manière plus centrée par rapport à ce bord.

Dans certains modes de réalisation, ladite course forme un angle avec la deuxième direction compris strictement entre 50° et 60°. En effet, compte tenu des tailles courantes de panneaux et de leurs ratios longueur/largeur, cette plage d'angle permet un maintien efficace d'une large gamme de panneaux depuis des petits panneau de 25,4x25,4 cm jusqu'à de grands panneau de 76,2x61 cm. En particulier, on parvient ainsi à maintenir au moins le point médian du quatrième bord des panneaux de taille conventionnelle.

Dans certains modes de réalisation, la course maximale d'au moins un dispositif d'immobilisation du deuxième type s'étend sur au moins 10 cm, de préférence sur au moins 40 cm, de préférence encore sur au moins 50 cm. Une telle course de plus de 50 cm pour le premier dispositif d'immobilisation du deuxième type et de plus de 40 cm pour le deuxième dispositif d'immobilisation du deuxième type permet de couvrir une large gamme de panneaux depuis des petits panneaux de 25,4x25,4 cm jusqu'à de grands panneaux de 76,2x61 cm.

Dans certains modes de réalisation, le débattement latéral maximal des dispositifs d'immobilisation du premier type est inférieur à 10 cm, de préférence inférieur à 5 cm. Un tel débattement réduit permet de minimiser le mouvement du dispositif d'immobilisation tout en laissant la place nécessaire à la mise en place du panneau. Il est permis en raison de la position constante des premier et deuxième bords du panneau par rapport à ces dispositifs d'immobilisation du premier type.

On note en outre à cette occasion, en ce qui concerne les dispositifs d'immobilisation du deuxième type, qu'il est possible de les prépositionner légèrement en retrait de la position attendue des troisième et quatrième bords du panneau en fonction de la taille des panneaux insolés dans une série donnée. Cette position de repos étant conservée pour toute la série, le mouvement du dispositif d'immobilisation est minimisé lors du chargement et du déchargement des panneaux d'une même série. De tels mouvements minimisés des dispositifs d'immobilisation des premier ou deuxième types permettent un gain de temps de cycle pour chaque panneau produit, ce qui augmente la rentabilité de la production.

Dans certains modes de réalisation, le plateau comprend au moins un premier dispositif de déplacement permettant de déplacer au moins un dispositif d'immobilisation du deuxième type.

Dans certains modes de réalisation, chaque dispositif d'immobilisation du deuxième type est équipé d'un tel dispositif de déplacement.

Dans certains modes de réalisation, le dispositif de déplacement comprend une vis d'Archimède coopérant avec un écrou solidaire dudit dispositif d'immobilisation du deuxième type.

Dans certains modes de réalisation, ladite vis d'Archimède est disposée sous la surface de travail.

Dans certains modes de réalisation, la vis d'Archimède est entraînée en rotation par un moteur, de préférence un moteur pas-à-pas, fixé sous la surface de travail.

Dans d'autres modes de réalisation, la vis d'Archimède est fixée, immobile, sous la surface de travail et l'écrou du dispositif d'immobilisation du deuxième type est entraînée en rotation par un moteur, de préférence un moteur pas-à-pas.

Dans certains modes de réalisation, au moins un, de préférence chaque, dispositif d'immobilisation comprend un applicateur de force actionné par un dispositif d'actionnement configuré pour abaisser l'applicateur de force vers la surface de travail dans l'état d'immobilisation et pour lever l'applicateur de force à distance de la surface de travail dans l'état de repos. Cet applicateur de force est l'organe en appui contre le panneau dans l'état d'immobilisation. Il est reculé dans l'état de repos afin de libérer le panneau.

Dans certains modes de réalisation, l'applicateur de force est une réglette oblongue s'étendant selon la première ou la deuxième direction respectivement. Cette forme permet d'appuyer sur une grande longueur du bord du panneau. Le cas échéant, elle permet notamment de plaquer efficacement les coins du panneau contre la surface de travail.

Dans certains modes de réalisation, la position de l'applicateur de force dans l'état de repos est plus haute et plus à l'extérieur que sa position dans l'état d'immobilisation. De cette manière, il est possible d'utiliser des panneaux d'épaisseurs différentes sans risque que l'applicateur de force ne butte contre sa tranche lors du passage vers l'état d'immobilisation. En outre, ceci permet dans l'état de repos de laisser passer le panneau lors de son chargement et de son déchargement.

Dans certains modes de réalisation, le dispositif d'actionnement d'au moins un dispositif d'immobilisation du premier type comprend un premier actionneur configuré pour lever ou abaisser l'applicateur de force et un deuxième actionneur configuré pour avancer ou reculer latéralement l'applicateur de force. Ces deux actionneurs étant distincts, ils sont dédiés chacun à une tache précise qu'ils peuvent exécuter efficacement indépendamment du comportement de l'autre actionneur. Ainsi, par exemple, la position horizontale de l'applicateur de force dans son état d'immobilisation sera correcte quelle que soit l'épaisseur du panneau. De même, la force déployée par le premier actionneur pourra être utilisée exclusivement pour immobiliser le panneau.

Toutefois, dans d'autres modes de réalisation, un unique actionneur pourrait assurer les deux mouvements simultanément.

Dans certains modes de réalisation, le premier actuateur comprend un vérin et une tringlerie de transmission.

Dans certains modes de réalisation, le deuxième actuateur comprend un vérin entraînant l'ensemble formé par le premier actuateur et l'applicateur de force.

Dans certains modes de réalisation, le dispositif d'actionnement d'au moins un dispositif d'immobilisation du deuxième type comprend un unique actionneur configuré pour lever ou abaisseur l'applicateur de force et le dispositif de déplacement correspondant est configuré pour avancer ou reculer latéralement l'applicateur de force. De cette manière, il est inutile de doter le dispositif d'actionnement d'un actionneur supplémentaire pour effectuer le mouvement de recul de l'applicateur de force.

Dans certains modes de réalisation, le premier actuateur comprend un vérin.

Dans certains modes de réalisation, le plateau comprend en outre un dispositif d'aspiration configuré pour maintenir un panneau contre la surface de travail par aspiration. Ce dispositif fonctionne en synergie avec les dispositifs d'immobilisation car le plaquage du panneau par ces derniers réduit les fuites entre le panneau et le système d'aspiration : dès lors, la force d'aspiration de l'ensemble des buses d'aspiration s'en trouve renforcée ce qui améliore d'autant le plaquage du panneau.

Dans certains modes de réalisation, le dispositif d'aspiration comprend une pompe à vide, de préférence du type Venturi, et un réseau d'orifices d'aspiration débouchant sur la surface de travail.

Dans certains modes de réalisation, le dispositif d'aspiration comprend une pluralité de réseaux d'aspiration correspondant à des zones distinctes de la surface de travail.

Dans certains modes de réalisation, le plateau comprend en outre un masque amovible configuré pour obturer au moins certains orifices d'aspiration. En fonction de la taille du panneau, ceci permet de masquer les orifices d'aspiration qui ne sont pas recouvert par le panneau afin de préserver la force d'aspiration du dispositif d'aspiration. De préférence, le plateau comprend un jeu de plusieurs masques possédant des géométries différentes.

Dans certains modes de réalisation, le plateau comprend en outre au moins un dispositif optique prévu dans la surface de travail à proximité de son premier et/ou de son deuxième bord, c'est-à-dire à moins de 5 cm dudit bord, de préférence moins de 3 cm. Le dispositif de positionnement assure ainsi que le panneau est bien positionné dans la zone de détection du dispositif optique.

Le présent exposé concerne également une machine d'insolation de panneaux comprenant un dispositif d'insolation et un plateau selon l'un quelconque des modes de réalisation précédents adapté pour présenter un panneau en vis-à-vis du dispositif d'insolation.

Dans certains modes de réalisation, ledit dispositif d'insolation est du type « direct imaging ».

Dans certains modes de réalisation, ledit plateau est mobile par rapport au dispositif d'insolation dans un plan parallèle à la surface de travail. Ceci permet de déplacer le panneau depuis le poste de chargement jusqu'en vis-à-vis du dispositif s'insolation. Ceci permet en outre de déplacer le panneau sous le dispositif d'insolation pour l'insoler morceau par morceau lorsque la tête d'insolation fonctionne de cette manière.

Dans certains modes de réalisation, ledit plateau est mobile par rapport au dispositif d'insolation selon les première et deuxième directions.

Les caractéristiques et avantages précités, ainsi que d'autres, apparaîtront à la lecture de la description détaillée qui suit, d'exemples de réalisation du dispositif et du procédé proposés. Cette description détaillée fait référence aux dessins annexés.

### BREVE DESCRIPTION DES DESSINS

Les dessins annexés sont schématiques et visent avant tout à illustrer les principes de l'invention.

Sur ces dessins, d'une figure (FIG) à l'autre, des éléments (ou parties d'élément) identiques sont repérés par les mêmes signes de référence.
La FIG 1 est une vue en perspective d'un plateau selon l'invention.
La FIG 2 est une vue de dessus de ce plateau.
Les FIG 3A et 3B représentent respectivement les états de repos et d'immobilisation des dispositifs d'immobilisation du plateau lorsqu'un panneau de grande taille est utilisé.
Les FIG 4A et 4B représentent respectivement les états de repos et d'immobilisation des dispositifs d'immobilisation du plateau lorsqu'un panneau de plus petite taille est utilisé.
La FIG 5 est une vue de dessous du plateau.
Les FIG 6A et 6B sont des vues de détail d'un dispositif d'immobilisation du premier type sous deux angles différents.
La FIG 7 est une vue de détail en perspective d'un dispositif d'immobilisation du deuxième type.
La FIG 8 est une vue de dessus d'une machine d'insolation selon l'invention.
La FIG 9 est une vue de profil de cette machine.

### DESCRIPTION DETAILLEE D'EXEMPLE(S) DE REALISATION

Afin de rendre plus concrète l'invention, un exemple de plateau et de machine d'insolation est décrit en détail ci-après, en référence aux dessins annexés. Il est rappelé que l'invention ne se limite pas à cet exemple.

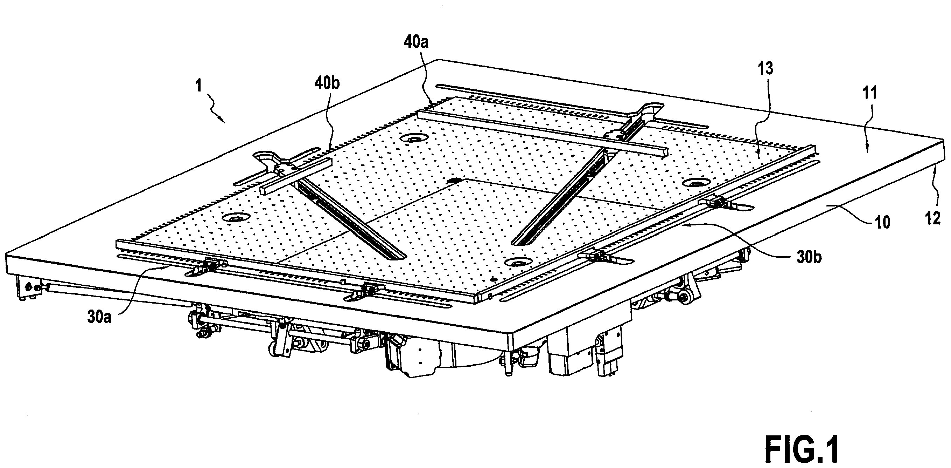

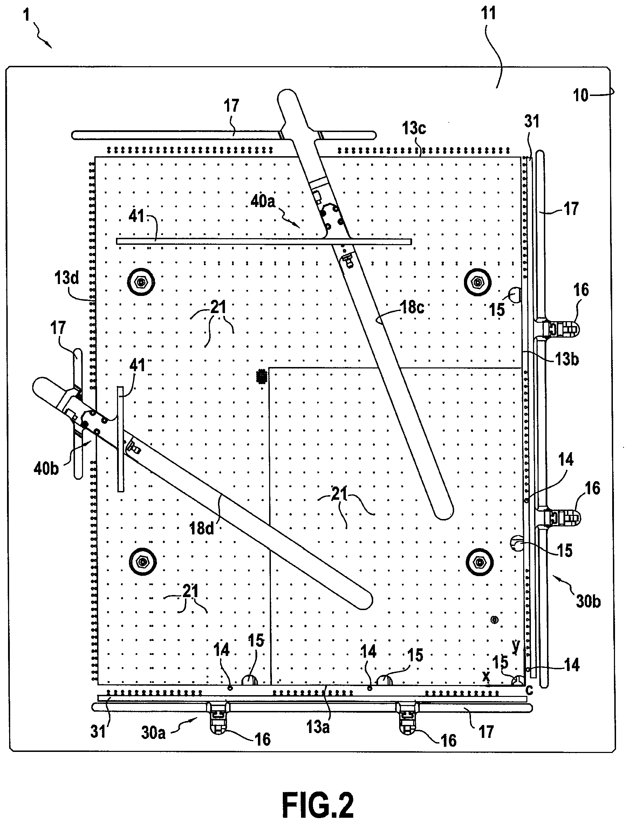

Les FIG 1 et 2 représentent un exemple de plateau 1 selon l'invention. Ce plateau 1 comprend un bâti 10 sensiblement parallélépipédique présentant une face supérieure 11 et une face inférieure 12. Afin de réduire au maximum la masse du plateau, et donc son inertie en mouvement, le bâti possède une faible épaisseur, inférieure à 30 mm, et sa surface inférieure 12 présente des nervures de renfort assurant la rigidité globale du plateau 1 et la planéité de sa surface supérieure 11, cette dernière présentant une tolérance inférieure à 200 µm. Ces nervures de renfort permettent en outre la fixation de dispositifs auxiliaires sur la surface inférieure 12 du bâti 10.

La face supérieure 11 du bâti 10 présente une zone rectangulaire s'étendant selon des directions orthogonales X, Y et définissant une surface de travail 13 configurée pour recevoir un panneau à insoler 90 sensiblement rectangulaire. La surface de travail 13 comprend ainsi des premier et troisième bords 13a, 13c parallèles à la direction X et des deuxième et quatrième bords 13b, 13d parallèles à la direction Y. Les premier et deuxième bords 13a, 13b sont donc adjacents et définissent à leur intersection un coin de référence C contre lequel chaque panneau 90 utilisé sera positionné, quelle que soit sa taille.

Afin d'aider ce positionnement, des taquets 14, prenant la forme de pions, sont disposés en surface du bâti 10 le long des premier et deuxième bords 13a, 13b de la surface de travail 13. De cette manière, le positionnement d'un panneau 90 contre le coin de référence C est précis et immédiat en poussant ledit panneau 90 contre les taquets 14.

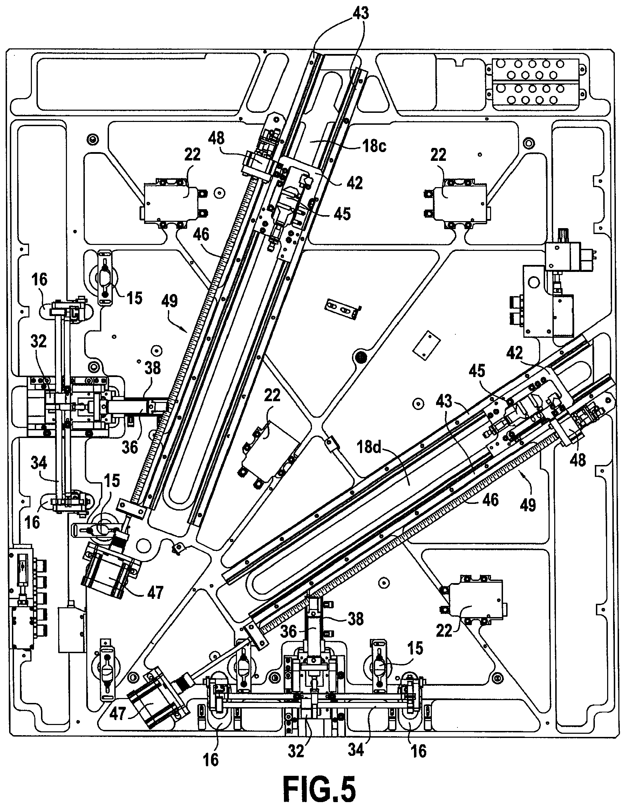

Des dispositifs optiques 15, fixés contre la surface inférieure 12 du bâti 10 (voir FIG 5) et débouchant sur la surface supérieure 11 au niveau de la surface de travail 13, sont en outre prévues à proximité des premier et deuxième bords 13a, 13b de la surface de travail 13. Dans le cadre d'une insolation recto-verso, ces dispositifs optiques 15 permettent de détecter, le cas échéant, des marquages prévus sur la première face du panneau 90 afin de faciliter l'alignement de l'image sur la deuxième face du panneau 90.

Le plateau 1 est en outre muni d'un dispositif d'aspiration permettant de maintenir par aspiration un panneau 90 contre la surface de travail 13. La surface de travail 13 comprend à cet effet des orifices d'aspiration 21 répartis sur la totalité de la surface de travail 13 et connectés par un réseau de tuyaux (non représentés) à une pluralité de pompes à vide 22 prévues sous le bâti 10. Ces orifices d'aspiration 21 peuvent être organisés en différentes zones d'aspiration activables indépendamment les unes des autres en fonction de la taille du panneau.

Afin d'améliorer le maintien du panneau 90 contre la surface de travail 13, et en particulier d'assurer un plaquage adéquat de ses côtés 90a-90d et de ses coins, le plateau 1 comprend en outre des dispositifs d'immobilisation d'un premier type 30a, 30b ainsi que des dispositifs de d'immobilisation d'un deuxième type 40a, 40b configurés chacun pour maintenir et plaquer un côté respectif du panneau 90.

Le premier dispositif d'immobilisation du premier type 30a est disposé sensiblement le long du premier bord 13a de la surface de travail 13. Il comprend un applicateur de force 31 prenant la forme d'une réglette s'étendant parallèlement à la première direction X sur une longueur au moins sensiblement égale à celle du premier bord 13a de la surface de travail 13. Dans cet exemple, la réglette mesure ainsi 61 cm de long.

Le deuxième dispositif d'immobilisation du premier type 30b est tout à fait analogue au premier 30a si ce n'est qu'il est disposé sensiblement le long du deuxième bord 13b de la surface de travail 13. Son applicateur de force 31, prenant également la forme d'une réglette, s'étend parallèlement à la deuxième direction Y sur une longueur au moins sensiblement égale à celle du deuxième bord 13b de la surface de travail 13. Dans cet exemple, la réglette mesure ainsi 75 cm de long.

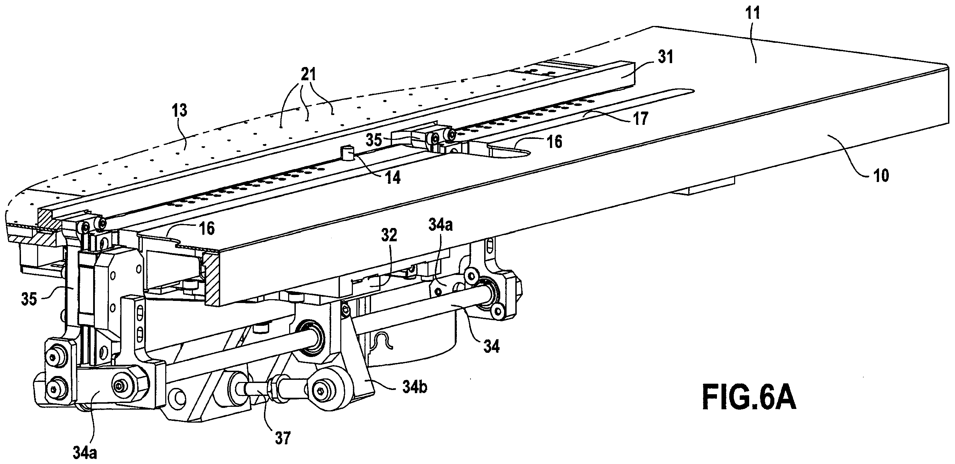

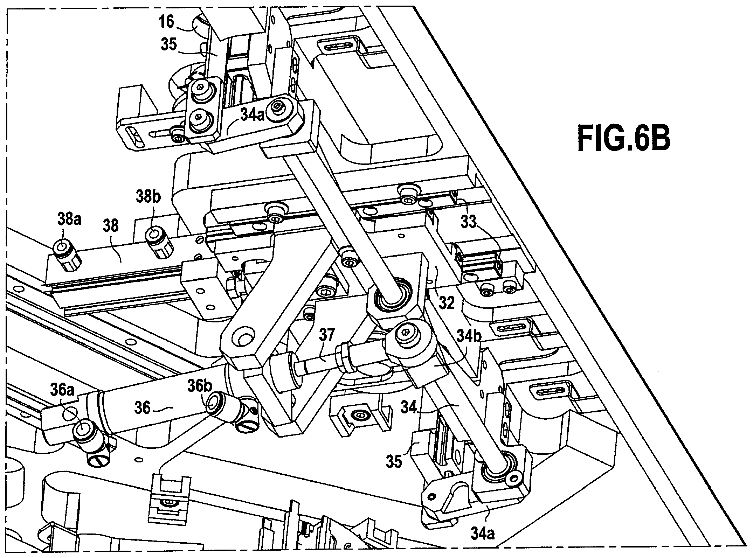

Comme cela est représenté sur les FIG 6A et 6B, chaque dispositif d'immobilisation du premier type 30a, 30b comprend un chariot 32 monté mobile le long de rails 33 disposés sous le bâti 10 perpendiculairement au premier bord 13a, respectivement deuxième bord 13b, de la surface de travail 13. Ce chariot porte en outre de manière pivotante une manivelle 34, sensiblement au niveau du milieu de cette dernière. L'applicateur de force 31 est monté sur cette manivelle 34 par l'intermédiaire de deux montants 35, prévus sensiblement aux premier et deuxième tiers de sa longueur, traversant le bâti au niveau de lumières 16, et connectés de manière pivotante à des manetons d'extrémité 34a de la manivelle 34.

Chaque dispositif d'immobilisation du premier type 30a, 30b comprend un premier actionneur 36 configuré pour déplacer l'applicateur de force 31 verticalement et un deuxième actionneur 38 configuré pour déplacer l'applicateur de force 31 horizontalement.

Le premier actionneur est un vérin pneumatique 36, muni d'une première et d'une deuxième entrée 36a, 36b, solidaire du chariot 32 et dont l'axe 37 du piston et connecté par un pivot à un maneton central 34b de la manivelle 34.

De cette manière, lorsqu'une pression pneumatique est admise dans la chambre du vérin 36 par la première entrée 36a, le piston est poussé vers l'extérieur, ce qui entraîne l'allongement de son axe 37 : la manivelle 34 est alors entraînée dans le sens antihoraire ce qui entraîne les montants 35, et donc l'applicateur de force 31, vers le bas, permettant ainsi d'exercer une force contre la surface de travail 13 ou contre le panneau 90 lorsqu'un tel panneau 90 est disposé sur la surface de travail 13.

A l'inverse, lorsqu'une pression pneumatique est admise dans la chambre du vérin 36 par la deuxième entrée 36b, le piston est repoussé vers l'intérieur, ce qui entraîne le raccourcissement de son axe 37 : la manivelle 34 est alors entraînée dans le sens horaire ce qui entraîne les montants 35 et l'applicateur de force 31 vers le haut, relâchant ainsi la pression exercée contre la surface de travail 13 ou le panneau 90.

Le deuxième actionneur est un autre vérin pneumatique 38, muni d'une première et d'une deuxième entrée 38a, 38b, dont l'axe du piston est connecté au chariot 32.

De cette manière, lorsqu'une pression pneumatique est admise dans la chambre du vérin 38 par la première entrée 38a, le piston est poussé vers l'extérieur, ce qui entraîne l'allongement de son axe : le chariot 32 et donc l'applicateur de force 31 sont ainsi entraînés latéralement vers l'extérieur, en retrait de la surface de travail 13.

A l'inverse, lorsqu'une pression pneumatique est admise dans la chambre du vérin 38 par la deuxième entrée 38b, le piston est poussé vers l'intérieur, ce qui entraîne le raccourcissement de son axe : le chariot 32 et donc l'applicateur de force 31 sont ainsi entraînés latéralement vers l'intérieur, en vis-à-vis de la surface de travail 13.

Le premier dispositif d'immobilisation du deuxième type 40a comprend un applicateur de force 41 prenant la forme d'une réglette s'étendant parallèlement à la première direction X de manière à pouvoir maintenir une majeure partie du troisième bord 90c du panneau 90 ainsi que son quatrième coin. Dans cet exemple, la réglette mesure ainsi 42 cm de long.

Le deuxième dispositif d'immobilisation du deuxième type 40b comprend également un applicateur de force 41 prenant la forme d'une réglette, cette dernière s'étendant parallèlement à la deuxième direction Y de manière à pouvoir maintenir une partie du quatrième bord 90d du panneau 90. Dans cet exemple, la réglette mesure ainsi 15 cm.

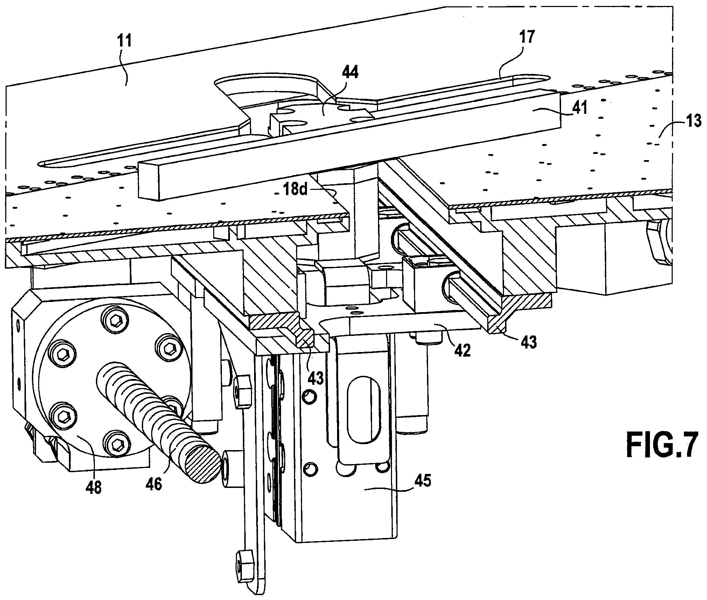

Comme cela est représenté sur les FIG 5 et 7, chaque dispositif d'immobilisation du deuxième type 40a, 40b comprend un chariot 42 monté mobile le long de rails 43 disposés sous le bâti 10 le long d'une course s'étendant sensiblement depuis le troisième bord 13c, respectivement le quatrième bord 13d, de la surface de travail 13 en diagonale vers l'intérieur de la surface de travail 13.

L'applicateur de force 41 est monté sur ce chariot 42 par l'intermédiaire d'un montant 44 traversant le bâti 10 à travers une lumière 18c, 18d s'étendant de l'extérieur vers l'intérieur de la surface de travail 13 parallèlement aux rails 43. De préférence, comme c'est le cas ici pour le deuxième dispositif d'immobilisation du deuxième type 40b, mais comme cela pourrait également être le cas dans d'autres exemples pour le premier dispositif d'immobilisation du deuxième type 40a, le montant 44 est prévu sensiblement au milieu de longueur de l'applicateur de force 41.

Chaque dispositif d'immobilisation du deuxième type 40a, 40b comprend un actionneur 45, plus précisément un vérin pneumatique, configuré pour déplacer le montant 44 et donc l'applicateur de force 41 verticalement.

Chaque dispositif d'immobilisation du deuxième type 40a, 40b est en outre équipé d'un dispositif de déplacement 49 configuré pour déplacer le chariot 42 le long des rails 43. Le dispositif de déplacement 49 comprend pour cela une vis d'Archimède 46 entraînée par un moteur pas-à-pas 47 ; le chariot 42 est quant à lui solidaire d'un écrou 48 engrenant sur la vis d'Archimède 46.

Ce dispositif de déplacement 49 permet ainsi d'entraîner le chariot 42, et donc l'applicateur de force 41, le long de sa course afin d'adapter sa position à la taille du panneau 90 utilisé.

Afin de protéger les applicateurs de force 31, 41 de chaque dispositif d'immobilisation 30a, 30b, 40a, 40b lorsque le plateau 1 n'est pas utilisé et de nettoyer ce dernier plus facilement, la face supérieure 11 du bâti 10 présente des rainures 17 prévues en retrait le long des bords 13a-13d de la surface de travail 13 ; ces rainures 17 sont prévues à la taille des applicateurs de force 31, 41 de manière à pouvoir les loger dans le bâti 10 lorsque le plateau 1 n'est pas utilisé.

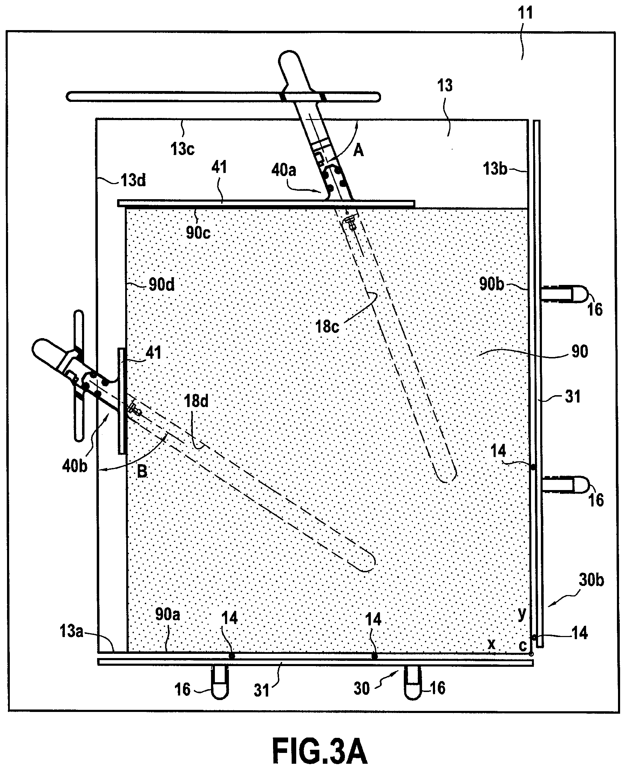

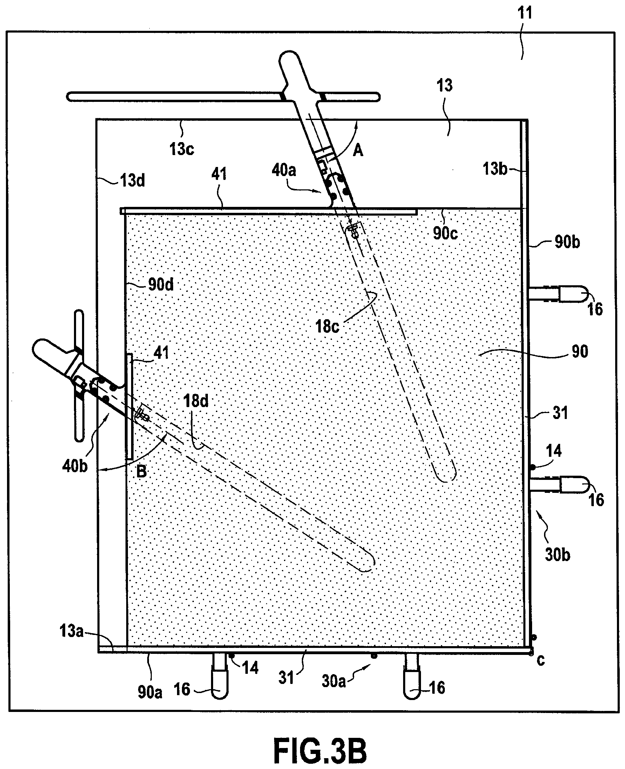

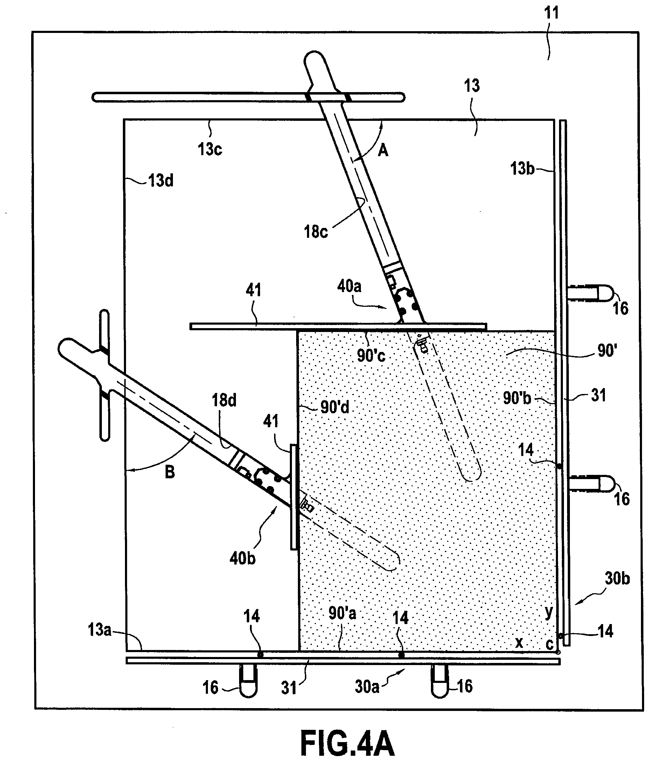

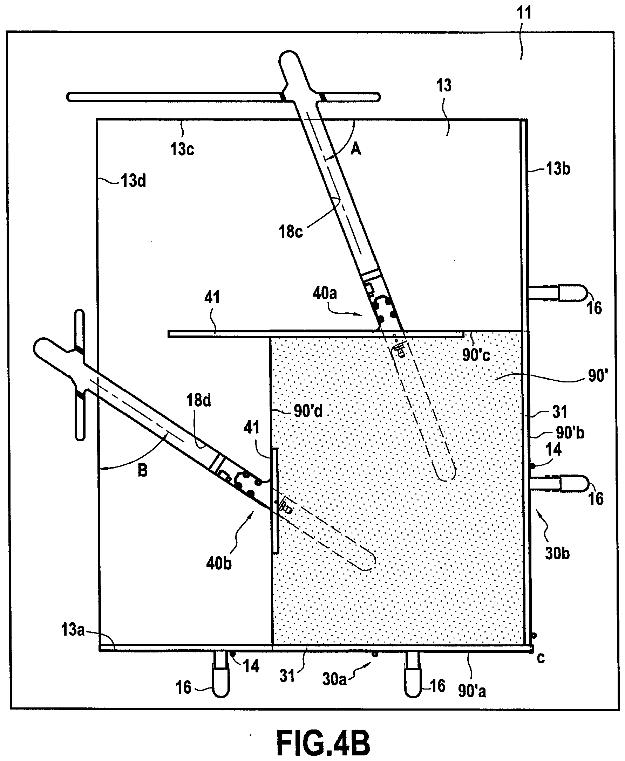

Le fonctionnement du plateau 1 va maintenant être décrit en référence aux FIG 3A, 3B, 4A et 4B. Dans l'exemple des FIG 3A et 3B, un panneau 90 de grande taille est utilisé tandis qu'un plus petit panneau 90' est utilisé dans l'exemple des FIG 4A et 4B.

Lorsqu'une nouvelle série de panneaux 90 doit être insolée, le plateau 1 est initialisé en renseignant la taille, c'est-à-dire la longueur et la largeur, des panneaux 90 utilisés. Les dispositifs d'immobilisation du deuxième type 40a, 40b sont alors entraînés par les dispositifs de déplacement de manière à amener chaque applicateur de force 41 dans une position de repos dans laquelle ils s'étendent le long et légèrement en retrait de la position attendue des troisième et quatrième bords 90c, 90d du panneau 90 et à distance de la surface supérieure 11 du bâti 10. Typiquement, on prévoit un écart horizontal d'environ 10 mm avec les bords du panneau 90 et un écart vertical d'environ 20 mm avec la surface supérieure 11.

Les dispositifs d'immobilisation du premier type 30a, 30b sont quant à eux actionnés de manière à amener chaque applicateur de force 31 dans un position de repos dans laquelle ils s'étendent le long et légèrement en retrait des premier et deuxième bords 13a, 13b de la surface de travail 13 et à distance de la surface supérieure 11 du bâti 10. Typiquement, on prévoit un écart horizontal d'environ 25 mm avec les bords 13a, 13b de la surface de travail 13 et un écart vertical d'environ 20 mm avec la surface supérieure 11.

Dans cette position initiale, un opérateur 99 peut placer un panneau vierge 90 sur la surface de travail 13 et le positionner contre les premier et deuxième bords 13a, 13b et le coin de référence C de la surface de travail 13 en le poussant contre les taquets 14. Cette configuration est représentée sur la FIG 3A.

Une fois le panneau correctement positionné, l'opérateur 99 peut déclencher le basculement des dispositifs d'immobilisation 30a, 30b, 40a et 40b dans leur état d'immobilisation. Dans cet état, les deuxièmes actionneurs 38 des dispositifs d'immobilisation du premier type 30a, 30b déplacent horizontalement les applicateurs de force 31 au-dessus des premier et deuxième bords 90a, 90b du panneau 90. Puis, les premiers actionneurs 36 de ces dispositifs d'immobilisation 30a, 30b déplacent verticalement les applicateurs de force 31 vers la surface de travail 13 de manière à atteindre une position d'immobilisation dans laquelle ils exercent une force verticale contre le panneau 90.

Quant aux dispositifs d'immobilisation du deuxième type 40a, 40b, lors du passage dans l'état d'immobilisation, les dispositifs de déplacement 49 déplacent horizontalement les applicateurs de force 41 au-dessus des troisième et quatrième bords 90c, 90d du panneau 90. Puis, les vérins 45 de ces dispositifs d'immobilisation 40a, 40b déplacent verticalement les applicateurs de force 41 vers la surface de travail 13 de manière à atteindre une position d'immobilisation dans laquelle ils exercent une force verticale contre le panneau 90. Cette configuration est représentée sur la FIG 3B.

Dans une telle configuration, le panneau 90 est maintenu fermement plaqué contre la surface de travail 13 et peut dès lors être présenté en vis-à-vis d'un dispositif d'insolation. On notera en particulier que les quatre coins du panneau 90, sensiblement toute la longueur de ses premier et deuxième bords 90a, 90b, une majeure partie de son troisième bord 90c, c'est-à-dire au moins la moitié de sa longueur, et au moins une portion médiane de son quatrième bord 90d sont ainsi plaqués par les applicateurs de force 31, 41.

Une fois l'insolation terminée, les dispositifs d'immobilisation reprennent leurs positions de repos de la FIG 3A, libérant ainsi le panneau 90 insolé : l'opérateur 99 peut alors retirer ce panneau 90 puis en déposer un nouveau pour commencer un nouveau cycle. On comprend naturellement à ce sujet que l'opérateur 99 pourrait tout à faire être remplacé par un dispositif mécanique de préhension et de convoyage assurant le chargement et le déchargement des panneaux 90 automatiquement.

Maintenant, lorsqu'un panneau 90' d'une taille inférieure est utilisé, les dispositifs d'immobilisation du deuxième type 40a, 40b sont avancés à l'intérieur de la surface de travail 13 grâce aux dispositifs de déplacement de manière à adapter leurs positions de repos et d'immobilisation à la taille de ce nouveau panneau 90'. Les courses de ces dispositifs d'immobilisation 40a, 40b sont obliques par rapport aux bords 13c, 13d de la surface de travail 13.

Plus précisément, la course du premier dispositif d'immobilisation du deuxième type 40a, que l'on peut apprécier en observant la lumière 18c, forme un angle A avec le troisième bord 13c de la surface de travail 13, c'est-à-dire avec la première direction X, environ égal à 70°. De cette manière, le premier dispositif d'immobilisation du deuxième type 40a peut maintenir le quatrième coin du panneau 90' et une majeure portion du troisième bord 90'c malgré la réduction de la taille du panneau 90'.

La course du deuxième dispositif d'immobilisation du deuxième type 40b, que l'on peut apprécier en observant la lumière 18d, forme quant à elle un angle B avec le quatrième bord 13d de la surface de travail 13, c'est-à-dire avec la deuxième direction Y, environ égal à 56°. De cette manière, le deuxième dispositif d'immobilisation du deuxième type 40b peut maintenir une portion médiane du quatrième bord 90'd malgré la réduction de la taille du panneau 90'.

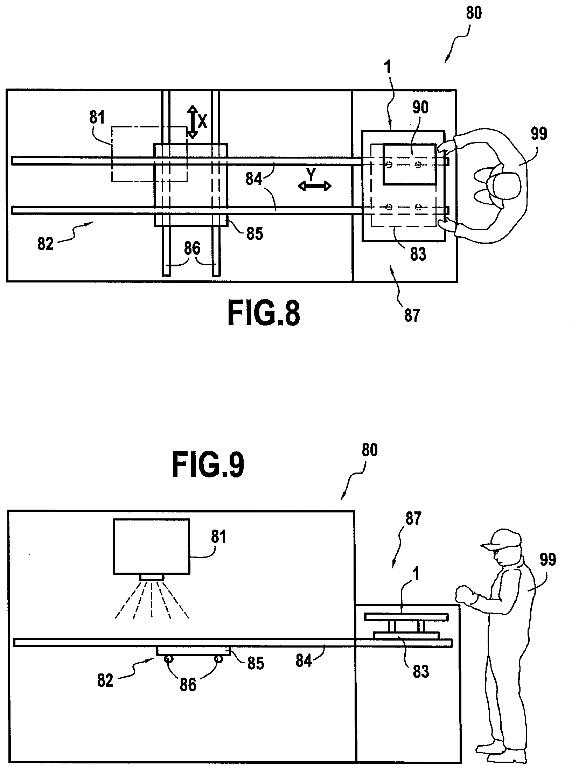

Un exemple de machine d'insolation 80 va maintenant être décrit en référence aux FIG 8 et 9. Cette machine d'insolation 80 comprend une tête d'insolation 81 du type direct imaging comprenant par exemple une matrice de micro-miroirs commandables capable de projeter une image sur la base d'un cliché numérique. La machine d'insolation 80 comprend en outre un plateau 1 conforme à l'invention, par exemple tel que décrit plus haut, pour maintenir un panneau 90 à insoler.

La machine 80 comprend en outre un dispositif de déplacement bidimensionnel 82 capable de déplacer le plateau 1 dans un plan horizontal selon les deux directions X et Y. A cette fin, le plateau peut être fixé sur un premier chariot 83 mobile le long de premier rails 84 parallèles à la première direction X, ces premier rails étant eux même portés par un deuxième chariot 85 mobile le long de deuxième rails 86 parallèles à la deuxième direction Y. De cette manière, il est possible de déplacer le plateau 1 entre une zone de chargement 87, au niveau de laquelle travaille un opérateur 99 chargé du chargement et du déchargement des panneaux 90, et une zone en vis-à-vis de la tête d'insolation 81.

De plus, lorsque le panneau 90 est plus grand que la taille de l'image que peut projeter la tête d'insolation, ce dispositif de déplacement permet l'insolation par morceaux du panneau 90 en lui faisant parcourir des positions successives en vis-à-vis de la tête d'insolation 81.

Afin d'assurer un alignement précis de l'image lors de sa projection, y compris lorsque l'image projetée évolue en même temps que le plateau 1 se déplace, ce dispositif de déplacement 82 est configuré pour assurer une précision absolue de positionnement du plateau 1 de l'ordre de 3 µm même lorsque le plateau 1 est en mouvement et ceci jusqu'à une vitesse de déplacement de l'ordre de 420 mm/s. En cas de nécessité, ce dispositif de déplacement 82 est configuré pour atteindre des pointes de vitesse jusqu'à 800 mm/s.

Les modes ou exemples de réalisation décrits dans le présent exposé sont donnés à titre illustratif et non limitatif, une personne du métier pouvant facilement, au vu de cet exposé, modifier ces modes ou exemples de réalisation, ou en envisager d'autres, tout en restant dans la portée de l'invention.

De plus, les différentes caractéristiques de ces modes ou exemples de réalisation peuvent être utilisées seules ou être combinées entre elles. Lorsqu'elles sont combinées, ces caractéristiques peuvent l'être comme décrit ci-dessus ou différemment, l'invention ne se limitant pas aux combinaisons spécifiques décrites dans le présent exposé. En particulier, sauf précision contraire, une caractéristique décrite en relation avec un mode ou exemple de réalisation peut être appliquée de manière analogue à un autre mode ou exemple de réalisation.

## Revendications

1. Plateau adapté pour présenter un panneau en vis-à-vis d'un dispositif d'insolation d'une machine d'insolation de panneaux, le plateau comprenant
une surface de travail (13) adaptée pour recevoir des panneaux (90) de tailles différentes, ladite surface de travail (13) étant sensiblement plane et possédant des premier et deuxième bords adjacents (13a, 13b) s'étendant selon des première et deuxième directions (X, Y) sensiblement orthogonales et définissant un coin de référence (C),
un premier et un deuxième dispositif d'immobilisation d'un premier type (30a, 30b) et au moins un premier dispositif d'immobilisation d'un deuxième type (40a), chacun étant actionnable entre un premier état d'immobilisation dans lequel il exerce une pression dirigée vers la surface de travail (13), définissant une position d'immobilisation, et un deuxième état de repos dans lequel ladite pression est relâchée,
**caractérisé en ce qu'**il comprend en outre un dispositif de positionnement (14) prévu le long d'au moins une partie du premier bord (13a) et le long d'au moins une partie du deuxième bord (13b),
**en ce que** les dispositifs d'immobilisation du premier type (30a, 30b) s'étendent respectivement le long d'au moins une partie des premier et deuxième bords (13a, 13b), leurs positions d'immobilisation étant fixes dans un plan parallèle à la surface de travail, et
**en ce que** le dispositif d'immobilisation du deuxième type (40a) est mobile dans un plan parallèle à la surface de travail (13) afin d'adapter sa position d'immobilisation en fonction de la taille du panneau (90) utilisé.

2. Plateau selon la revendication 1, dans lequel le dispositif de positionnement comprend au moins un taquet (14) prévu contre le premier bord (13a) et/ou le deuxième bord (13b) de la surface de travail (13).

3. Plateau selon la revendication 1 ou 2, dans lequel le premier dispositif d'immobilisation du deuxième type (40a) est mobile en translation le long d'une course s'étendant au moins depuis un troisième bord (13c) de la surface de travail (13) vers l'intérieur de la surface de travail (13) sensiblement en direction du premier dispositif d'immobilisation du premier type (30a).

4. Plateau selon la revendication 3, dans lequel la course du premier dispositif d'immobilisation du deuxième type (40a) forme un angle (A) avec la première direction (X) compris strictement entre 45° et 90°, de préférence entre 65° et 75°.

5. Plateau selon l'une quelconque des revendications 1 à 4, comprenant un deuxième dispositif d'immobilisation du deuxième type (40b),
dans lequel le deuxième dispositif d'immobilisation du deuxième type (40b) est mobile en translation le long d'une course s'étendant au moins depuis un quatrième bord (13d) de la surface de travail (13) vers l'intérieur de la surface de travail (13) et sensiblement en direction du deuxième dispositif d'immobilisation du premier type (30b), et
dans lequel ladite course forme un angle (B) avec la deuxième direction (Y) compris strictement entre 45° et 90°, de préférence entre 50° et 60°.

6. Plateau selon l'une quelconque des revendications 3 à 5, dans lequel la course maximale d'au moins un dispositif d'immobilisation du deuxième type (40a, 40b) s'étend sur au moins 10 cm, de préférence sur au moins 35 cm, de préférence encore sur au moins 50 cm, et dans lequel le débattement latéral maximal des dispositifs d'immobilisation du premier type (30a, 30b) est inférieur à 10 cm, de préférence inférieur à 5 cm.

7. Plateau selon l'une quelconque des revendications 1 à 6, comprenant au moins un premier dispositif de déplacement (49) permettant de déplacer au moins un dispositif d'immobilisation du deuxième type (40a, 40b).

8. Plateau selon la revendication 7, dans lequel le premier dispositif de déplacement (49) comprend une vis d'Archimède (46) coopérant avec un écrou solidaire (48) dudit dispositif d'immobilisation du deuxième type (40a, 40b).

9. Plateau selon l'une quelconque des revendications 1 à 8, dans lequel au moins un, de préférence chaque, dispositif d'immobilisation (30a, 30b, 40a, 40b) comprend un applicateur de force (31, 41) actionné par un dispositif d'actionnement (36, 38, 45) configuré pour abaisser l'applicateur de force (31, 41) vers la surface de travail (13) dans l'état d'immobilisation et pour lever l'applicateur de force (31, 41) à distance de la surface de travail (13) dans l'état de repos.

10. Plateau selon la revendication 9, dans lequel la position de l'applicateur de force (31, 41) dans l'état de repos est plus haute et plus à l'extérieur que sa position dans l'état d'immobilisation.

11. Plateau selon la revendication 9 ou 10, dans lequel le dispositif d'actionnement d'au moins un dispositif d'immobilisation du premier type (30a, 30b) comprend un premier actionneur (36) configuré pour lever ou abaisser l'applicateur de force (31) et un deuxième actionneur (38) configuré pour avancer ou reculer latéralement l'applicateur de force (31).

12. Plateau selon la revendication 7 ou 8 et l'une quelconque des revendications 9 à 11, dans lequel le dispositif d'actionnement d'au moins un dispositif d'immobilisation du deuxième type (40a, 40b) comprend un unique actionneur (45) configuré pour lever ou abaisseur l'applicateur de force (41) et dans lequel le dispositif de déplacement (49) correspondant est configuré pour avancer ou reculer latéralement l'applicateur de force (41).

13. Plateau selon l'une quelconque des revendications 1 à 12, comprenant en outre un dispositif d'aspiration (21, 22) configuré pour maintenir un panneau (90) contre la surface de travail (13) par aspiration.

14. Machine d'insolation de panneaux comprenant un dispositif d'insolation (81) et un plateau (1) selon l'une quelconque des revendications précédentes adapté pour présenter un panneau (90) en vis-à-vis du dispositif d'insolation (81).

15. Machine selon la revendication 14, dans laquelle ledit plateau (1) est mobile par rapport au dispositif d'insolation (81) dans un plan parallèle à la surface de travail.

## Patentansprüche

1. Tablett zum Anordnen einer Platte gegenüber einer Belichtungsvorrichtung einer Plattenbelichtungsmaschine, wobei das Tablett umfasst
eine Arbeitsfläche (13) zum Aufnehmen von Platten (90) verschiedener Größen, wobei die Arbeitsfläche (13) im Wesentlichen flach ist und erste und zweite angrenzende Kanten (13a, 13b) aufweist, die sich gemäß einer ersten und zweiten im Wesentlichen orthogonalen Richtung (X, Y) erstrecken und eine Bezugsecke (C) definieren,
eine erste und eine zweite Haltevorrichtung eines ersten Typs (30a, 30b) und mindestens eine erste Haltevorrichtung eines zweiten Typs (40a), wobei jede zwischen einem ersten Haltezustand, in dem sie einen gegen die Arbeitsfläche (13) gerichteten Druck ausübt, wobei eine Befestigungsposition definiert wird, und einem zweiten Ruhezustand, in dem der Druck gelöst wird, betätigbar ist,
**dadurch gekennzeichnet, dass** sie ferner eine Positionierungsvorrichtung (14) umfasst, die entlang mindestens eines Teils der ersten Kante (13a) und entlang mindestens eines Teils der zweiten Kante (13b) vorgesehen ist,
dadurch, dass sich die Haltevorrichtungen des ersten Typs (30a, 30b) jeweils entlang mindestens eines Teils der ersten und zweiten Kante (13a, 13b) erstrecken, wobei ihre Haltepositionen in einer Ebene befestigt sind, die parallel zur Arbeitsfläche verläuft, und
dadurch, dass die Haltevorrichtung des zweiten Typs (40a) in einer Ebene verschiebbar ist, die parallel zur Arbeitsfläche (13) verläuft, um ihre Halteposition in Abhängigkeit von der Größe der verwendeten Platte (90) anzupassen.

2. Tablett nach Anspruch 1, wobei die Positionierungsvorrichtung mindestens einen Anschlag (14) umfasst, der an der ersten Kante (13a) und/oder der zweiten Kante (13b) der Arbeitsfläche (13) vorgesehen ist.

3. Tablett nach Anspruch 1 oder 2, wobei die erste Haltevorrichtung des zweiten Typs (40a) entlang einer Strecke translatorisch verschiebbar ist, die sich mindestens von einer dritten Kante (13c) der Arbeitsfläche (13) ins Innere der Arbeitsfläche (13) im Wesentlichen in Richtung der ersten Haltevorrichtung des ersten Typs (30a) erstreckt.

4. Tablett nach Anspruch 3, wobei die Strecke der ersten Haltevorrichtung des zweiten Typs (40a) einen Winkel (A) mit der ersten Richtung (X) bildet, der exakt zwischen 45° und 90°, vorzugsweise zwischen 65° und 75° liegt.

5. Tablett nach einem der Ansprüche 1 bis 4, umfassend eine zweite Haltevorrichtung des zweiten Typs (40b),
wobei die zweite Haltevorrichtung des zweiten Typs (40b) entlang einer Strecke translatorisch verschiebbar ist, die sich mindestens von einer vierten Kante (13d) der Arbeitsfläche (13) ins Innere der Arbeitsfläche (13) im Wesentlichen in Richtung der zweiten Haltevorrichtung des ersten Typs (30b) erstreckt, und
wobei die Strecke einen Winkel (B) mit der zweiten Richtung (Y) bildet, der exakt zwischen 45° und 90°, vorzugsweise zwischen 50° und 60° liegt.

6. Tablett nach einem der Ansprüche 3 bis 5, wobei sich die maximale Strecke mindestens einer Haltevorrichtung des zweiten Typs (40a, 40b) über mindestens 10 cm, vorzugsweise über mindestens 35 cm, noch bevorzugter über mindestens 50 cm erstreckt und wobei der maximale seitliche Ausschlag der Haltevorrichtungen des ersten Typs (30a, 30b) kleiner als 10 cm, vorzugsweise kleiner als 5 cm ist.

7. Tablett nach einem der Ansprüche 1 bis 6, umfassend mindestens eine erste Verschiebevorrichtung (49), die es ermöglicht, mindestens eine Haltevorrichtung des zweiten Typs (40a, 40b) zu verschieben.

8. Tablett nach Anspruch 7, wobei die erste Verschiebevorrichtung (49) eine archimedische Schraube (46) umfasst, die mit einer Mutter (48) zusammenwirkt, die fest mit der Haltevorrichtung des zweiten Typs (40a, 40b) verbunden ist.

9. Tablett nach einem der Ansprüche 1 bis 8, wobei mindestens eine, vorzugsweise jede Haltevorrichtung (30a, 30b, 40a, 40b) einen Kraftüberträger (31, 41) umfasst, der von einer Betätigungsvorrichtung (36, 38, 45) betätigt wird, die gestaltet ist, um den Kraftüberträger (31, 41) im Haltezustand auf die Arbeitsfläche (13) abzusenken und um den Kraftüberträger (31, 41) im Ruhezustand auf einen Abstand von der Arbeitsfläche (13) anzuheben.

10. Tablett nach Anspruch 9, wobei die Position des Kraftüberträgers (31, 41) im Ruhezustand höher und weiter außen ist als seine Position im Haltezustand.

11. Tablett nach Anspruch 9 oder 10, wobei die Betätigungsvorrichtung mindestens einer Haltevorrichtung des ersten Typs (30a, 30b) einen ersten Betätiger (36) umfasst, der gestaltet ist, um den Kraftüberträger (31) anzuheben oder abzusenken, und einen zweiten Betätiger (38), der gestaltet ist, um den Kraftüberträger (31) seitlich vorzuschieben oder zurückzuziehen.

12. Tablett nach Anspruch 7 oder 8 und einem der Ansprüche 9 bis 11, wobei die Betätigungsvorrichtung mindestens einer Haltevorrichtung des ersten Typs (40a, 40b) einen einzigen Betätiger (45) umfasst, der gestaltet ist, um den Kraftüberträger (41) anzuheben und abzusenken, und wobei die entsprechende Verschiebevorrichtung (49) gestaltet ist, um den Kraftüberträger (41) seitlich vorzuschieben oder zurückzuziehen.

13. Tablett nach einem der Ansprüche 1 bis 12, umfassend ferner eine Saugvorrichtung (21, 22), die gestaltet ist, um eine Platte (90) durch Saugwirkung gegen die Arbeitsfläche (13) zu halten.

14. Plattenbelichtungsmaschine, umfassend eine Belichtungsvorrichtung (81) und ein Tablett (1) nach einem der vorhergehenden Ansprüche, das eingerichtet ist, um eine Platte (90) gegenüber der Belichtungsvorrichtung (81) anzuordnen.

15. Maschine nach Anspruch 14, wobei das Tablett (1) in Bezug auf die Belichtungsvorrichtung (81) in einer Ebene verschiebbar ist, die parallel zur Arbeitsfläche verläuft.

## Claims

1. A tray adapted to present a panel facing an exposure device in a panel exposure machine, the tray comprising:
a work surface (13) adapted to receive panels (90) of different sizes, said work surface (13) being substantially plane and possessing first and second adjacent edges (13a, 13b) extending along substantially orthogonal first and second directions (X, Y) defining a reference corner (C); and
first and second holder devices (30a, 30b) of a first type and at least a first holder device (40a) of a second type, each holder device being actuatable between a holding, first state in which it exerts pressure directed towards the work surface (13), thereby defining a holding position, and a rest, second state in which said pressure is released;
the tray being **characterized in that** it further comprises a positioning device (14) arranged along at least a portion of the first edge (13a) and along at least a portion of the second edge (13b);
**in that** the holder devices (30a, 30b) of the first type extend along at least a portion of the first and second edges (13a, 13b) respectively, their holding positions being fixed in a plane parallel to the work surface; and
**in that** the holder device (40a) of the second type is movable in a plane parallel to the work surface (13) in order to adapt its holding position as a function of the size of the panel (90) in use.

2. A tray according to claim 1, wherein the positioning device comprises at least one stop (14) provided against the first edge (13a) and/or the second edge (13b) of the work surface (13).

3. A tray according to claim 1 or claim 2, wherein the first holder device (40a) of the second type is movable in translation along a stroke extending at least from a third edge (13c) of the work surface (13) towards the interior of the work surface (13) substantially towards the first holder device (30a) of the first type.

4. A tray according to claim 3, wherein the stroke of the first holder device of the second type (40a) forms an angle (A) with the first direction (X) that lies strictly between 45° and 90°, and preferably between 65° and 75°.

5. A tray according to any one of claims 1 to 4, including a second holder device (40b) of the second type,
wherein the second holder device (40b) of the second type is movable in translation along a stroke extending at least from a fourth edge (13d) of the work surface (13) towards the inside of the work surface (13) and substantially towards the second holder device (30b) of the first type; and
wherein said stroke forms an angle (B) with the second direction (Y) lying strictly between 45° and 90°, and preferably between 50° and 60°.

6. A tray according to any one of claims 3 to 5, wherein the maximum stroke of at least one holder device (40a, 40b) of the second type extends over at least 10 cm, preferably over at least 35 cm, more preferably over at least 50 cm, and wherein the maximum lateral travel of the holder devices (30a, 30b) of the first type is less than 10 cm, preferably less than 5 cm.

7. A tray according to any one of claims 1 to 6, including at least one first mover device (49) for moving at least one holder device (40a, 40b) of the second type.

8. A tray according to claim 7, wherein the first mover device (49) comprises a wormscrew (46) co-operating with a nut (48) secured to said holder device (40a, 40b) of the second type.

9. A tray according to any one of claims 1 to 8, wherein at least one and preferably each holder device (30a, 30b, 40a, 40b) includes a force applicator (31, 41) actuated by an actuator device (36, 38, 45) configured to lower the force applicator (31, 41) towards the work surface (13) in the holding state and to lift the force applicator (31, 41) to a distance from the work surface (13) in the rest state.

10. A tray according to claim 9, wherein the position of the force applicator (31, 41) in the rest state is higher and further out than its position in the holding state.

11. A tray according to claim 9 or claim 10, wherein the actuator device of at least one holder device (30a, 30b) of the first type comprises a first actuator (36) configured to lift or lower the force applicator (31) and a second actuator (38) configured to cause the force applicator (31) to advance or retreat laterally.

12. A tray according to claim 7 or claim 8 and according to any one of claims 9 to 11, wherein the actuator device of at least one holder device (40a, 40b) of the second type comprises a single actuator (45) configured to lift or to lower the force applicator (41), and wherein the corresponding mover device (49) is configured to cause the force applicator (41) to advance or retreat laterally.

13. A tray according to any one of claims 1 to 12, further including a suction device (21, 22) configured to retain a panel (90) against the work surface (13) by suction.

14. A panel exposure machine comprising an exposure device (81) and a tray (1) according to any preceding claim and adapted to present a panel (90) facing the exposure device (81).

15. A machine according to claim 14, wherein said tray (1) is movable relative to the exposure device (81) in a plane parallel to the work surface.
